# EUROPÄISCHE PATENTSCHRIFT

(11) **EP 0 464 738 B1**
(45) Veröffentlichungstag und Bekanntmachung des Hinweises auf die Patenterteilung: **15.03.1995**
(21) Anmeldenummer: 91110860.3
(22) Anmeldetag: 01.07.1991
(51) Int. Cl.: H01L 31/042

(54) **Vorrichtung zur Nutzung der Solarenergie mit Solarzellen**
Device for the use of solar energy with solar cells
Dispositif pour l'utilisation de l'énergie solaire à l'aide de cellules solaires

(30) Priorität: 04.07.1990 DE 4021339
(43) Veröffentlichungstag der Anmeldung: 08.01.1992
(73) Patentinhaber: Schottel-Werft Josef Becker GmbH & Co KG., D-56322 Spay (DE)
(72) Erfinder: Naujeck, Andreas, Dipl.-Ing., W-5206 Neunkirchen-Seelscheid 2 (DE); Schneider, Stephan, Dipl.-Ing., W-5401 Spay (DE)
(74) Vertreter: Walter, Helmut, Dipl.-Ing.

(56) Entgegenhaltungen:
- DE-A- 3 513 910
- DE-A- 3 801 090
- DE-U- 8 709 552
- DER SPIEGEL Nr. 32, 5. August 1991, Seiten 65,66, Hamburg, DE; "Ohne Tank in den Busch"

## Beschreibung

Die Erfindung bezieht sich auf eine Vorrichtung zur Nutzung der Sonnenenergie gemäß dem Gattungsbegriff des Anspruchs 1.

Damit bezieht sich die Erfindung auf die Zuordnung von Solarzellen zu einer Tragstruktur.

Aufgabe der Erfindung ist die Schaffung einer besonders zweckmäßigen Ausgestaltung der Zuordnung von Solarzellen zu einer Tragstruktur, die hochfest und extrem leicht sein soll und die vorzugsweise in das Oberdeck eines Wasserfahrzeuges integrierbar sein soll. Die Zuordnung von Solarzellen zur Energiegewinnung soll in möglichst einfacher Weise erfolgen, um den Preis der Zuordnung in tragbaren Grenzen zu halten. Die Zuordnung soll mit wenigen, wenig störanfälligen Mitteln erfolgen. Als weiteres Hauptziel soll die Solarzellenzuordnung mit möglichst geringem Gewicht verbunden sein, damit die Zuordnung über den besonderen Anwendungsfall hinaus universell einsetzbar ist.

Der Lösung der Aufgabe dient die Erfindung gemäß dem Anspruch 1, die durch die Merkmale der weiteren Ansprüche in besonders zweckmäßiger Weise ausgebildet und angewendet wird. Ein Verfahren zur Herstellung einer solchen Vorrichtung ist in Patentanspruch 14 angegeben.

Um der Erfüllung der Aufgabe möglichst nahezukommen, sieht die Erfindung und damit die Verwendung von rahmenlos gekapselten Solarzellen, sogenannten Solarlaminaten vor, eine Tragstruktur für die Aufnahme vorzugsweise einer Mehrzahl solcher Solarlaminate und die Fixierung dieser Mehrzahl der Solarlaminate auf der Oberseite dieser Tragkonstruktion insbesondere mittels einer glatt über die Solarlaminate gespannten, an den Rändern der Tragkonstruktion befestigten, durchscheinenden Folie.

Die Erfindung ist nachfolgend anhand der Zeichnung näher erläutert. In der Zeichnung zeigen:

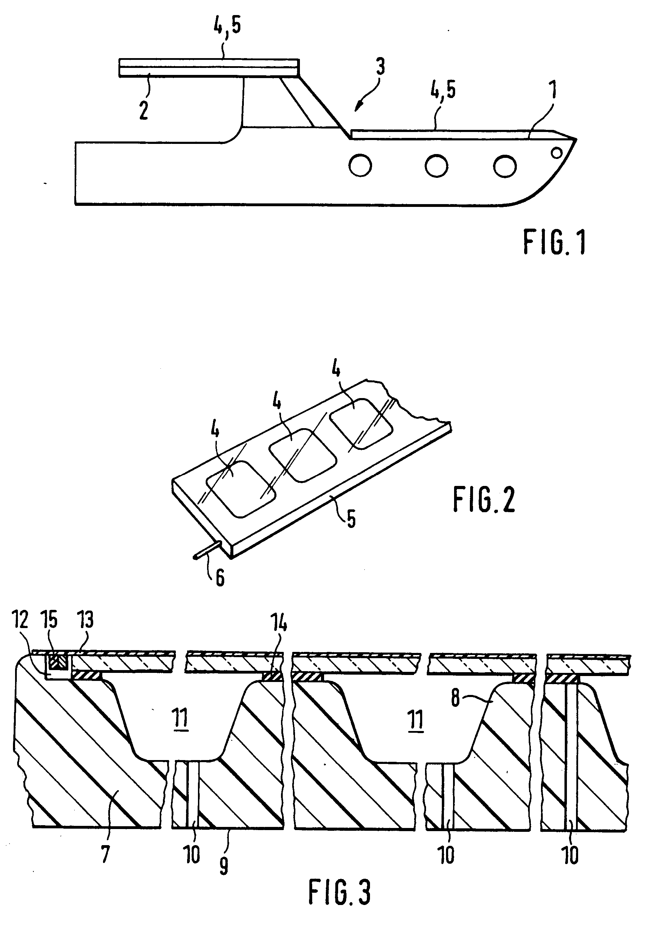

- Fig. 1: einen erfindungsgemäß ausgerüsteten Schiffstyp in Seitenansicht,
- Fig. 2: ein Solarlaminat, wie es erfindungsgemäß zur Anwendung kommt und
- Fig. 3: eine erfindungsgemäße Solarzellenzuordnung in einem Querschnitt durch eines der beiden Dachteile, die bei einem Schiff gemäß Fig. 1 erfindungsgemäß mit Solarlaminaten belegt sind.

Die Oberseiten des Vordecks 1 und des Daches 2 eines entsprechend ausgebildeten Schiffes oder Bootes 3 sind mit gekapselten Solarzellen belegt. Diese Solarzellen sind als Solarlaminate, also Solarmodule ohne umfassenden Rahmen ausgebildet. Mehrere Solarzellen 4 sind in einem bestimmten Muster vorzugsweise in einer Reihe oder aber auch mehreren Reihen, die einander kreuzen neben- bzw. hintereinander in einen lichtdurchlässigen Folienstreifen 5 oder einer entsprechend dünnen Platte gekapselt, d.h. von diesem bzw. dieser allseits umschlossen, wobei der die Solarzellen 4 umschliessende Folienstreifen 5 bzw. die Platte aus zwei aufeinanderliegenden und flächig miteinander verbundenen Einzelstreifen bzw. -platten bestehen kann, die zwischen sich die Solarzellen 4 halten und von denen der Streifen bzw. die Platte, der bzw. die im eingebauten Zustand der Sonneneinstrahlung zugekehrt ist, lichtdurchlässig, der andere Streifen bzw. die andere Platte ebenfalls aus diesem Material oder gegebenenfalls einem anderen, entsprechenden, aber möglicherweise auch lichtundurchlässigen Material bestehen kann. Die Solarzellen eines solchen "Solarlaminates" 4,5 sind miteinander elektrisch verschaltet, und sie haben eine gemeinsame Stromabführung 6. Üblicherweise ist ein solches Solarlaminat ringsum von einer Einfaßleiste eingefaßt, im Zusammenhang mit der Erfindung finden jedoch rahmenlose Laminate Anwendung, d.h. eine Einfaßleiste ist nicht vorgesehen. Sowohl beim Dach als auch beim Vordeck sind eine Vielzahl solcher Solarlaminate in Gruppen von Reihen angeordnet und miteinander elektrisch verschaltet.

Zur Aufnahme der gekapselten Solarzellen und damit als Tragstruktur sind nun Vordeck 1 und/oder Dach 2 selbst ausgebildet. Dach, bzw. Vordeck sind als sogenannte Sandwichkonstruktion ausgebildet, bei der eine obere Deckplatte und eine untere Deckplatte durch einen Starrschaum auf Abstand voneinander gehalten werden und gegeneinander versteift sind, indem der Starrschaum ganzflächig sowohl mit der oberen, als auch mit der unteren Deckplatte verbunden ist. Im Zusammenhang mit der Erfindung wird vorbereiteter und vorzugsweise durch Zuschnitt zweckgerecht konturierter Starrschaum 7 zwischen zwei Matten 8,9 eingelegt, wobei der Starrschaum 7 Durchgangslöcher 10 aufweist, die sich zwischen seinen beiden Flächen senkrecht zu den Mattenebenen erstrecken. Auf die Außenseite der einen Matte wird Kunstharz im fließfähigen Zustand aufgetragen und auf die Außenseite der anderen Matte wird ein Vakuum aufgebracht, so daß das Kunstharz durch die erstgenannte Matte, die Durchgangslöcher 10 und die zweitgenannte Matte gesaugt wird und so im Erstarren einen Verbundkörper aus den beiden Matten 8,9 und dem Starrschaumkörper 7 mit extrem glatten, festen Oberflächen bildet. Derart hergestellte Sandwichkonstruktionen sind an sich bekannt und müssen deshalb insoweit nicht näher erläutert werden. Die obere Deckplatte ist bei der erfindungsgemäß zur Anwendung kommenden Sandwichkonstruktion nicht eben, sondern wellenförmig profiliert ausgeführt, um einerseits eine Stützung, andererseits eine Hinterlüftung der Solarzellen zu gewährleisten, wobei die durch die Profilierung entstehenden Schächte 11 (Wellentäler) gleichzeitig oder alternativ der Aufnahme der elektrischen Installation und Verkabelung dienen. Zweckmäßigerweise verjüngen sich die Wellentäler nach innen konisch.

Durch die Profilierung der oberen Deckplatte bzw. -matte wird eine sehr hohe Festigkeit in Längsrichtung erreicht, die Festigkeit in Querrichtung durch den Verbund der oberen und unteren Deckplatten bzw. -matten 8,9 mit dem dazwischenliegenden Starrschaum 7 erreicht. Die Konstruktion des Stützkörpers zur Aufnahme der gekapselten Solarzellen 4,5 ist selbsttragend und benötigt keine Stützkonstruktion.

Die Herstellung der Tragkonstruktion bzw. des Stützkörpers mit unterer Deckplatte 9 und profilierter oberer Deckplatte 8 sowie dazwischenliegendem Starrschaum 7 erfolgt in einem Schritt, so daß eine kostengünstige Serienfertigung möglich ist.

Jedes der Solarzellenlaminate liegen am Umfang auf dem vertieften Rand 12 der Tragkonstruktion auf, wobei die Vertiefung der Dicke der Solarzellenlaminate entspricht, so daß Solarzellenlaminate und diese umgebende Tragstruktur in einer allenfalls flach gewölbten horizontalen Ebene liegen.

Die Fixierung der gekapselten Solarzellen erfolgt nun mit einer Folie 13, die glatt, blasen- und faltenfrei und zweckentsprechend gespannt über die Solarlaminate und die Ränder der Tragkonstruktion geführt und mit einem wasserlöslichen Kleber aufgeklebt ist. Eine entsprechend dimensionierte Folie, die u.U. aus einzelnen Folienbahnen zusammengesetzt ist, kann die Gesamtheit von Solarzellenlaminate von Vordeck bzw. Dach gegenüber der jeweiligen Tragkonstruktion fixieren, oder die Solarzellenlaminate können zu mehreren Gruppen zusammengefaßt sein, wobei die Solarzellenlaminate jeder Gruppe durch eine Folie fixiert werden. Die Zahl der in einem Laminat 4,5 zusammengefaßten Solarzellen richtet sich nach den Gegebenheiten, u.U. kann ein Solarzellenlaminat auch nur eine Zelle einschließen.

Die zu verwendende Folie ist an sich wieder handelsüblich. Sie ist hochfest, hoch lichtdurchlässig, extrem UV-lichtbeständig, kratzfest und vor dem Auflegen einseitig mit wasserlöslichem Klebstoff beschichtet.

Ist die Folie völlig blasenfrei und eben auf die zugehörigen Solarlaminate durch Kleben aufgebracht, so entstehen keine Verluste durch Reflexionen und die Verluste sind insgesamt so gering, daß der Wirkungsgrad der Solarzellenlaminate durch die Folie nicht, bzw. im geringstmöglichen Maße beeinträchtigt wird.

Vor dem Aufbringen der Folie werden die mit der Folie in Berührung kommenden Teile befeuchtet, so daß der Kleber wirksam wird.

Insgesamt liegt eine Zuordnung vor, die aus wenigen, betriebssicheren und preiswert zu beschaffenden Teilen besteht und mit geringem Arbeitsaufwand zusammenzufügen ist, und die Zuordnung ist über eine lange Betriebszeit hinweg betriebssicher. Wird aber ein Solarzellenlaminat schadhaft, so ist durch zeitweiliges, gegebenenfalls auch nur teilweises Entfernen der Folie eine Reparatur bzw. ein Auswechseln möglich. Die Zuordnung ist danach ebenso einfach wieder möglich. Trotzdem ist die Folie ein zwar optimales, aber nicht das einzige Mittel, um die Laminate daran zu hindern, nach oben von der Tragstruktur abzuheben.

Um Verspannungen zu vermeiden und etwaige Maßabweichungen auszugleichen, sind die Solarlaminate über Moosgummistreifen 14 und dgl. auf der Tragstruktur aufgelegt. Diese Moosgummistreifen insbesondere zwischen den Solarzellenlaminaten und dem Rand der Tragstruktur verhindert außerdem das Eindringen von Feuchtigkeit zwischen Solarlaminate und Tragstruktur. Diesem Zweck dient zusätzlich das Ausfüllen von Spalten mit dauerelastischem Dichtungsmaterial 15, beispielsweise Silikongummi.

Der Schaumstoffstützkörper 7 kann ein- oder mehrstückig sein.

## Patentansprüche

1. Vorrichtung zur Nutzung der Solarenergie mit Solarzellen (4), die einer Tragstruktur zugeordnet und elektrisch miteinander verbunden sind sowie einen Außenanschluß zur Abführung der elektrischen Energie aufweisen, **dadurch gekennzeichnet**, daß mehrere Solarzellen Teile eines rahmenlosen Solarzellenlaminats (5) sind, bei dem die Solarzellen (4) nebeneinander in einem folien- oder plattenförmigen Träger (5) gekapselt sind, dessen zumindest eine, dem Sonnenlicht zuzukehrende Seite eben und lichtdurchlässig ist und daß dieses Solarzellenlaminat in der Tragstruktur liegt, die aus zwei Deckschichten (8, 9) und einer dazwischen liegenden stützenden Schaumschicht (7) besteht, einen ringsumlaufenden vertieften Rand (12) bildet, auf dem das Laminat mit der Oberseite der Tragstruktur bündig aufliegt und der zwischen zwei parallelen Randabschnitten wellenförmig ausgebildet ist, um auf höherliegenden Abschnitten das Solarzellenlaminat zu stützen und mit den tiefer liegenden Abschnitten Kanäle (11) zur Führung eines Kühlmittels sowie der Aufnahme von Energieführungsmitteln zu dienen.

2. Vorrichtung nach Anspruch 1, **dadurch gekennzeichnet**, daß das Laminat (4,5) mit der Tragstruktur (7,8,9) fest verbunden ist.

3. Vorrichtung nach Anspruch 1 oder 2, **dadurch gekennzeichnet**, daß mehrere Laminate (4,5) nebeneinanderliegend einer gemeinsamen Tragstruktur zugeordnet sind.

4. Vorrichtung nach Anspruch 2 oder 3, **dadurch gekennzeichnet**, daß die Verbindung zwischen Solarzellenlaminat(en) und Tragstruktur (7,8,9) mit einer lichtdurchlässigen, dehnfesten, resistenten Folie (13) erfolgt, die falten- und blasenfrei auf der Oberseite der Tragstruktur (7,8,9) neben dem Laminat/den Laminaten (4,5) und auf dem Laminat/den Laminaten selbst fest gespannt aufliegt.

5. Vorrichtung nach Anspruch 3 oder 4, **dadurch gekennzeichnet**, daß die Folie (13) auf dem Laminat/den Laminaten (4,5) und der Tragstruktur (7,8,9) aufgeklebt ist.

6. Vorrichtung nach Anspruch 5, **dadurch gekennzeichnet**, daß die Folie (13) mit einem wasserlöslichen Kleber aufgeklebt ist.

7. Vorrichtung nach einem der Ansprüche 1 bis 6, **dadurch gekennzeichnet**, daß das Laminat bzw. die Laminate (4,5) auf der Tragstruktur (7,8,9) über eine elastische Zwischenlage (14) abgestützt ist.

8. Vorrichtung nach Anspruch 7, **dadurch gekennzeichnet**, daß die Zwischenlage aus einem oder entsprechend mehreren Moosgummistreifen (14) besteht.

9. Vorrichtung nach einem der Ansprüche 1 bis 8, **dadurch gekennzeichnet**, daß ein Spalt zwischen Solarzellenlaminat/Solarzellenlaminaten (4,5) und Tragstruktur (7,8,9) mit einer dauerelastischen Masse (15) abgedichtet ist, beispielsweise Silikon- bzw. Kunstgummi.

10. Vorrichtung nach einem der Ansprüche 1 bis 9, **dadurch gekennzeichnet**, daß die Wellen im wesentlichen rechteckig sind.

11. Vorrichtung nach Anspruch 10, **dadurch gekennzeichnet**, daß die Wellenecken abgerundet sind und sich die Wellentäler zum Grund hin konisch verjüngen.

12. Vorrichtung nach einem der Ansprüche 1 bis 11, **dadurch gekennzeichnet**, daß die Baugruppe aus Laminat(en) und die Tragstruktur eine horizontale ebene, gegebenenfalls flach gewölbte, der Sonneneinstrahlung unterliegende Fläche (1,2) eines Schiffes (3) ist.

13. Vorrichtung nach Anspruch 12, **dadurch gekennzeichnet**, daß die Fläche eine begehbare Deckfläche (1) ist.

14. Verfahren zur Herstellung einer Vorrichtung nach einem der Ansprüche 1 bis 13, **dadurch gekennzeichnet**, daß die Tragstruktur aus zwei Stapelfasermatten (8, 9) besteht zwischen denen vorgefertigte und zubereitete Schaumstoffprofile eingelegt sind, die senkrecht zu den Mattenebenen verlaufende Verbindungskanäle (10) zwischen Ober- und Unterseite umschließen und die mit den Matten durch ein Kunstharz (7) verbunden sind, das im fließfähigen Zustand auf die Außenseite der einen Matte aufgetragen und im Vakuumverfahren durch diese Matte, durch die Verbindungskanäle und die zweite Matte gesaugt und danach zum Erhärten gebracht wurde, so daß die beiden Oberseiten der Tragstruktur aus harzgetränkten Stapelfasermatten besonderer Glätte bestehen.

## Claims

1. A device for using solar energy and comprising solar cells (4) associated with a bearing structure and electrically connected to one another and also comprising an external connection for discharging the electric energy, characterised in that a number of solar cells are part of a frameless solar-cell laminate (5) in which the solar cells (4) are encapsulated side by side in a carrier (5) in the form of a sheet or plate and having at least one side which faces the sunlight and is flat and permeable to light, and the solar-cell laminate lies in the bearing structure, which comprises two surface layers (8, 9) and a foam layer (7) in between and forms an annular recessed edge (12) on which the laminate rests flush with the upper surface of the bearing structure, the edge being corrugated between two parallel edge portions so as to support higher parts of the solar-cell laminate and so as to co-operate with the lower parts to form ducts (11) for conveying a coolant and for receiving energy guide means.

2. A device according to claim 1, characterised in that the laminate (4, 5) is permanently connected to e bearing structure (7, 8, 9).

3. A device according to claim 1 or 2, characterised in that a number of laminates (4, 5) side by side are associated with a common bearing structure.

4. A device according to claim 2 or 3, characterised in that the connection between the solar-cell laminate or laminates and the bearing structure (7, 8, 9) is via a light-permeable, non-stretch resistant foil (13) which is tightly stretched and rests without folds or bubbles on the surface of the bearing structure (7, 8, 9) alongside the laminate or laminates (4, 5) and on the laminate or laminates themselves.

5. A device according to claim 3 or 4, characterised in that the foil (13) is stuck to the laminate or laminates (4, 5) and the bearing structure (7, 8, 9).

6. A device according to claim 5, characterised in that the foil (13) is stuck with a water-soluble adhesive.

7. A device according to any of claims 1 to 6, characterised in that the laminate or laminates (4, 5) are supported on the bearing structure (7, 8, 9) via a resilient intermediate layer (14).

8. A device according to claim 7, characterised in that the intermediate layer comprises one or a suitable number of foam rubber strips (14).

9. A device according to any of claims 1 to 8, characterised in that a gap between the solar-cell laminate or laminates (4, 5) and bearing structure (7, 8, 9) is sealed by a permanently resilient material (15), e.g. silicone rubber or artificial rubber.

10. A device according to any of claims 1 to 9, characterised in that the corrugations are substantially rectangular.

11. A device according to claim 10, characterised in that the corners of the corrugations are rounded and the troughs of the corrugations taper conically towards the base.

12. A device according to any of claims 1 to 11, characterised in that the sub-assembly, which comprises one or more laminates and the bearing structure, is a horizontal flat, optionally slightly curving, surface (1, 2) of a ship (3) exposed to solar radiation.

13. A device according to claim 12, characterised in that the surface is a walkable deck surface (1).

14. A method of manufacturing a device according to any of claims 1 to 13, characterised in that the bearing structure comprises two staple-fibre mats (8, 9) between which prefabricated and prepared foam profiles are inserted and surround between the top and bottom surface connecting ducts (10) extending at right angles to the mat planes and are connected to the mats by a synthetic resin (7) which is applied in a fluid state to the outside of one mat and sucked by a vacuum process through the mat, through the connecting ducts and the second mat and then hardened, so that the two top surfaces of the bearing structure consist of particularly smooth resin-impregnated staple-fibre mats.

## Revendications

1. Dispositif permettant l'exploitation de l'énergie solaire au moyen de cellules solaires (4), qui sont associées à une structure de support, sont reliées électriquement les unes aux autres, et comportent un élément de connexion extérieur pour l'évacuation de l'énergie électrique, caractérisé en ce que plusieurs cellules solaires font partie d'un stratifié de cellules solaires (5) sans cadre, dans lequel les cellules solaires (4) sont insérées de manière étanche et côte à côte dans un substrat (5) sous forme de feuille ou de plaque, dont l'un au moins des côtés, dirigé vers la lumière du soleil, est plan et transparent à la lumière, et en ce que ce stratifié de cellules solaires repose sur la structure de support, qui est composée de deux couches de recouvrement (8, 9) et d'une couche de mousse (7) de soutien disposée entre les deux précédentes, qui forme une bordure périphérique (12) en retrait, sur laquelle repose le stratifié en affleurant le côté supérieur de la structure de support, et qui entre deux tronçons de bordure parallèles, présente une configuration ondulée, pour soutenir le stratifié de cellules solaires par les tronçons de plus grande hauteur, et servir à conduire un fluide de refroidissement ainsi qu'à recevoir des moyens transmission de l'énergie, au moyen des tronçons situés plus bas.

2. Dispositif selon la revendication 1, caractérisé en ce que le stratifié (4, 5) est relié de manière fixe à la structure de support (7, 8, 9).

3. Dispositif selon la revendication 1 ou 2, caractérisé en ce que plusieurs stratifiés (4, 5) disposés côte à côte, sont associés à une structure de support commune.

4. Dispositif selon la revendication 2 ou 3, caractérisé en ce que la liaison entre le ou les stratifié(s) et la structure de support (7, 8, 9) s'effectue au moyen d'une feuille (13) transparente à la lumière, résistante et insensible à la dilatation, qui repose, en étant tendue sans plis et sans cloques, sur le côté extérieur de la structure de support (7, 8, 9), à côté du ou des stratifié(s) (4, 5) et sur le stratifié lui-même ou les stratifiés eux-mêmes.

5. Dispositif selon la revendication 3 ou 4, caractérisé en ce que la feuille (13) est collée sur le ou les stratifié(s) (4, 5) et sur la structure de support (7, 8, 9).

6. Dispositif selon la revendication 5, caractérisé en ce que la feuille est collée au moyen d'une colle soluble dans l'eau.

7. Dispositif selon l'une des revendications 1 à 6, caractérisé en ce que le stratifié ou les stratifiés (4, 5) s'appuie(nt) sur la structure de support (7, 8, 9) par interposition d'une couche intermédiaire (14) élastique.

8. Dispositif selon la revendication 7, caractérisé en ce que la couche intermédiaire est constituée par une ou respectivement plusieurs bandes de caoutchouc cellulaire (14).

9. Dispositif selon l'une des revendications 1 à 8, caractérisé en ce qu'un interstice entre le stratifié ou les stratifiés de cellules solaires (4, 5) et la structure de support (7, 8, 9) est comblé de manière étanche, par une pâte (15) à élasticité permanente, par exemple du caoutchouc au silicones ou du caoutchouc synthétique.

10. Dispositif selon l'une des revendications 1 à 9, caractérisé en ce que les ondes sont sensiblement de forme rectangulaire.

11. Dispositif selon la revendication 10, caractérisé en ce que les coins des ondes sont arrondis et que les creux d'ondes se rétrécissent de manière conique en direction du fond.

12. Dispositif selon l'une des revendications 1 à 11, caractérisé en ce que le module de construction formé par le ou les stratifié(s) et la structure de support, constitue la surface (1, 2) d'un bateau (3), horizontale et plane, le cas échéant légèrement bombée, et subissant l'action du rayonnement solaire.

13. Dispositif selon la revendication 12, caractérisé en ce que la surface et une surface de pont (1) sur laquelle il est possible de marcher.

14. Procédé de fabrication d'un dispositif selon l'une des revendications 1 à 13, caractérisé en ce que la structure de support est formée de deux nappes de soie de coton (8, 9), entre lesquelles sont insérés des profilés de mousse préfabriqués et préparés au préalable, qui enserrent des canaux de liaison (10) s'étendant perpendiculairement aux plans des nappes, entre le côté supérieur et le côté inférieur, et qui sont assemblés aux nappes par une résine synthétique (7) appliquée à l'état fluide sur le côté extérieur de l'une des nappes, aspirée, selon un procédé sous vide, au travers de cette nappe, des canaux de liaison et de la seconde nappe, et amenée ensuite à durcir, de sorte que les deux surfaces extérieures de la structure de support sont formées par des nappes de soie de coton imprégnées de résine, particulièrement lisses.
